# EUROPÄISCHE PATENTSCHRIFT

(11) **EP 1 880 425 B1**
(45) Veröffentlichungstag und Bekanntmachung des Hinweises auf die Patenterteilung: **31.07.2013**
(21) Anmeldenummer: 06754991.5
(22) Anmeldetag: 03.05.2006
(51) Int. Cl.: H01L 33/34, H01L 33/16

(54) **VERSETZUNGSBASIERTER LICHTEMITTER**
DISLOCATION-BASED LIGHT EMITTER
EMETTEUR DE LUMIERE BASE SUR UNE DISLOCATION

(30) Priorität: 03.05.2005 DE 102005021296; 16.02.2006 DE 102006008025
(43) Veröffentlichungstag der Anmeldung: 23.01.2008
(73) Patentinhaber: IHP GmbH-Innovations for High Performance Microelectronics / Leibniz-Institut für innovative Mikroelektronik, 15236 Frankfurt / Oder (DE)
(72) Erfinder: KITTLER, Martin, 15234 Frankfurt (Oder) (DE); REICHE, Manfred, 06132 Halle (DE); ARGUIROV, Tzanimir, 03044 Cottbus (DE); SEIFERT, Winfried, 15230 Frankfurt (Oder) (DE)
(74) Vertreter: Eisenführ, Speiser & Partner
(86) Internationale Anmeldenummer: PCT/EP2006/062030
(87) Internationale Veröffentlichungsnummer: WO 2006/117389

(56) Entgegenhaltungen:
- US-A1- 2003 150 376
- SEKIGUCHI T ET AL: "Cathodoluminescence study on the tilt and twist boundaries in bonded silicon wafers" MATERIALS SCIENCE AND ENGINEERING B, ELSEVIER SEQUOIA, LAUSANNE, CH, Bd. 91-92, 30. April 2002 (2002-04-30), Seiten 244-247, XP004355536 ISSN: 0921-5107 in der Anmeldung erwähnt
- KVEDER V ET AL: "Room-temperature silicon light-emitting diodes based on dislocation luminescence" APPLIED PHYSICS LETTERS, AIP, AMERICAN INSTITUTE OF PHYSICS, MELVILLE, NY, US, Bd. 84, Nr. 12, 22. März 2004 (2004-03-22), Seiten 2106-2108, XP012060850 ISSN: 0003-6951
- SVEINBJOERNSSON E OE ET AL: "ROOM TEMPERATURE ELECTROLUMINESCENCE FROM DISLOCATION-RICH SILICON" APPLIED PHYSICS LETTERS, AIP, AMERICAN INSTITUTE OF PHYSICS, MELVILLE, NY, US, Bd. 69, Nr. 18, 28. Oktober 1996 (1996-10-28), Seiten 2686-2688, XP000642924 ISSN: 0003-6951
- WAI LEK NG ET AL: "AN EFFICIENT ROOM-TEMPERATURE SILICON-BASED LIGHT-EMITTING DIODE" NATURE, NATURE PUBLISHING GROUP, LONDON, GB, Bd. 410, Nr. 6825, 8. März 2001 (2001-03-08), Seiten 192-194, XP000991178 ISSN: 0028-0836
- AKATSU T; SCHOLZ R; GOSELE U: "Dislocation structure in low-angle interfaces between bonded Si(001) wafers", JOURNAL OF MATERIALS SCIENCE, 1 May 2004 (2004-05-01), pages 3031-3039, USA DOI: 10.1023/B:JMSC.0000025829.40338.04

## Beschreibung

Die Erfindung betrifft ein Licht emittierendes Halbleiterbauelement auf Siliziumbasis.

Die Entwicklung der Halbleitertechnologie weist in Richtung höherer Integrationsdichte integrierter Schaltungen und schnellerer Signalverarbeitung. Zukünftige integrierte Schaltungen werden voraussichtlich daher nicht mehr allein auf elektronischer Signalerzeugung und Signalverarbeitung beruhen, sondern zunehmend optische und optoelektronische Bauelemente integrieren, um eine weitere Steigerung der Verarbeitungsgeschwindigkeit und eine Reduzierung der Verlustleistung zu erzielen. Weiterhin wird angestrebt, durch Multiplexing optischer Signale in Wellenleitern auf dem Chip die architektonische Komplexität zu verringern. Für die optische Signalverarbeitung sind infrarote Spektralbereiche prädestiniert. Basismaterial der Halbleitertechnologie ist Silizium. Bekannte, effiziente Leucht- und Laserdioden im infraroten Spektralbereich sind jedoch nicht aus Silizium, sondern insbesondere aus III-V-Halbleitern wie Galliumarsenid, Indiumarsenid oder Indiumgalliumarsenid hergestellt. Diese sind nur in Form aufwändiger Hybridverfahren in die siliziumbasierte Halbleitertechnologie integrierbar. Solchen Verfahren werden keine Anwendungschancen eingeräumt.

Silizium ist lange Zeit nicht als geeignetes Basismaterial für Lichtemitter angesehen worden, weil Silizium im Gegensatz zu beispielsweise Galliumarsenid und vielen anderen Halbleitermaterialien ein so genannter indirekter Halbleiter ist. Bei indirekten Halbleitern liegen das Energieminimum der Leitungsbandzustände, entsprechend der minimalen Energie freier Elektronen, und das Energiemaximum der Valenzbandzustände, entsprechend der minimalen Energie freier Löcher, als Funktion des Ladungsträgerimpulses betrachtet nicht bei demselben Impulswert. Da ein Photon bekanntlich praktisch impulsfrei ist, muss die Impulserhaltung bei der strahlenden Rekombination von freien Elektron-Loch-Paaren im Silizium durch eine Wechselwirkung der Ladungsträger mit dem Kristallgitter gewährleistet werden, nämlich durch die Erzeugung von impulsbehafteten Gitterwellen in Form eines oder mehrerer Phononen. Die Vernichtung eines freien Elektron-Lochpaares unter Lichtemission erfordert im Silizium also die Erzeugung eines Phonons zusätzlich zum erwünschten Photon. Ein solcher Prozess hat eine geringere Wahrscheinlichkeit als die unmittelbare Erzeugung allein eines Photons, wie sie in so genannten direkten Halbleitern wie Galliumarsenid erfolgt, bei denen die Energieminima von Elektronen und Löchern auf denselben Impulswert fallen.

Trotzdem sind in jüngerer Zeit effiziente, auf Band-Band-Rekombination beruhende Lichtemitter auf Siliziumbasis entwickelt worden, vgl. beispielsweise die DE 10 2004 042 997 A1.

Für die optoelektronische Anwendung sind jedoch insbesondere Lichtemitter im spektralen Fenster um 1,5 µm (etwa 0,8 eV) oder im spektralen Fenster um 1,3 µm (etwa 0,94 eV) erforderlich. Diese Spektralgebiete sind unter Ausnutzung einer strahlenden Band-Band-Rekombination nur mit einer Silizium-Germanium-Legierung mit hohen Germaniumanteil erreichbar. Die für die erforderliche Lichtausbeute benötigte Defektarmut ist in solchen Legierungen jedoch nur schwer realisierbar.

Alternative Ansätze verfolgen daher eine "Züchtung" bekannter niederenergetischer Lichtemissionen des Silizium, die nach heutigem Wissensstand auf Kristalldefekte wie Versetzungen zurückzuführen sind. Da die an der Lichtemission beteiligten Energieniveaus an den Defekten lokalisiert sind, können die Energierelaxationsprozesse, die zur Lichtemission führen, ohne Phononenbeteiligung stattfinden.

Aus der Veröffentlichung (XP000642924) E. Ö. Sveinbjömsson et al. "Room temperature electroluminescence from dislocation-rich silicon", Applied Physics Letters, Vol. 69, No. 18 (1996), 2686-2688 ist bekannt, dass Versetzungen in Silizium zu spezifischen Lumineszenzerscheinungen führen, die als D-Linien bezeichnet werden.

Aus der Veröffentlichung T. Akatsu et al., "Dislocation structure in low-angle interfaces between bonded Si(001) wafers", Journal of Materials Science 39 (2004), 3031-3039 sind Einzelheiten der kristallinen Struktur von Versetzungen bekannt, die beim Verbinden zweier Silizium(001)-Wafer durch Waferbonding entstehen.

Aus der Veröffentlichung US 2003/0150376 A1 ist es bekannt, im Kristallgitter auf atomarer Skala lokale Störungen zu erzeugen und diese Störungen in einem Halbleiterbauelement mit einer p-Typ-Schicht und einer n-Typ-Schicht zur Erzeugung von Licht zu nutzen. Die Lichtemission hat bei Raumtemperatur jedoch ein Maximum, welches sich im Wellenlängenbereich zwischen 1,0 µm und 1,2 µm erstreckt, der für die hier anvisierten optoelektronischen Anwendungsgebiete wenig interessant ist.

Aus der als nächstliegender Stand der Technik betrachteten Veröffentlichung (XP012060850) von V. Kveder, M. Badylevitch et al., "Room-temperature silicon light-emitting diodes based on dislocation luminescence", Applied Physics Letters, Volume 84, Number 12, Seiten 2106 - 2108 ist eine Leuchtdiode bekannt, die bei Raumtemperatur eine Elektrolumineszenz zeigt, die von der sogenannten D1-Linie dominiert wird. Die D1-Lumineszenz im Silizium wird nach derzeit vorherrschender Meinung von strahlenden Energierelaxationsprozessen an Versetzungsstrukturen hervorgerufen, vgl. T. Sekiguchi, S. Ito, A. Kanai, "Cathodoluminescence study on the tilt and twist boundaries in bonded silicon wafers", Materials Science and Engeneering B 91-92 (2002), Seiten 244 - 247 (XP004355536).

V. Kveder et al. erzielen eine Erhöhung der Effizienz der D1-Lumineszenz bei Raumtemperatur durch die Unterdrückung nicht-strahlender Rekombinationsprozesse, die von Verunreinigungen hervorgerufen werden, welche in der Umgebung der Versetzungen lokalisiert sind.

Nachteil der von Kveder et al. beschriebenen Leuchtdiode ist, dass sich ihre Lumineszenz über einen relativ weiten Spektralbereich erstreckt und auch eine ausgeprägte Schulter bei höheren Energien um 0,85 eV hat. Diese Lumineszenz wird als D2-Lumineszenz bezeichnet. Sie ist jedoch für optoelektronische Anwendungen uninteressant. Die von Kveder et. al zur Herstellung der Leuchtdioden verwendeten plastisch deformierten Substrate haben darüber hinaus den Nachteil, dass die darin enthaltenen unregelmäßigen Versetzungsanordnungen nach derzeitigem Stand der Technik nicht ausreichend reproduzierbar hergestellt werden können.

Das der Erfindung zugrunde liegende technische Problem ist es, eine siliziumbasierte Licht emittierende Halbleiterdiode anzugeben, deren Lichtemission eine geringere spektrale Breite in den für optoelektronische Anwendungen interessanten Spektralbereichen um 1,3 µm oder um 1,5 µm aufweist.

Dieses technische Problem wird gemäß der Erfindung durch ein Licht emittierendes Halbleiterbauelement gemäß dem Anspruch 1 gelöst.

In überraschender Weise hat sich gezeigt, dass durch Einstellung geeigneter Paare von Drehwinkel und Kippwinkel Versetzungsnetzwerke an der ersten Grenzfläche gebildet werden, die eine spektral begrenzte und intensive Lumineszenz hervorrufen, die je nach Winkelpaar ganz überwiegend von der D1- Emission oder von der D3-Emission hervorgerufen wird. Dabei deckt die D1-Lumineszenz den spektralen Bereich um 1,55 Mikrometer ab und die D3-Lumineszenz den Spektralbereich um 1,3 Mikrometer. Aufgrund der gleichzeitig erzielten Unterdrückung konkurrierender strahlender Energierelaxationsprozesse erhöht sich die Quanteneffizienz der Lichtemission im jeweils optimierten Lumineszenzbereich, also entweder im Bereich der D1-Lumineszenz oder im Bereichder D3-Lumineszenz.

Der Begriff "absolutes Maximum der emittierten Lichtintensität" bezieht sich, was den Intensitätsvergleich mit anderen Lichtemissionen angeht, auf den spektralen Bereich zwischen 0,7 und 1,2 eV, erfasst also den Bereich der an sich bekannten D-Lumineszenzen und der Lichtemissionen mit Energien nahe der Bandlückenenergie des Silizium von etwa 1,1 eV. Ein Intensitätsvergleich mit außerhalb dieses Spektralbereiches zwischen 0,7 und 1,2 eV liegenden Lichtemissionen spielt für die Definition des Licht emittierenden Halbleiterbauelements der vorliegenden Erfindung keine Rolle.

Nachfolgend werden bevorzugte Ausführungsbeispiele des erfindungsgemäßen Licht emittierenden Halbleiterbauelements erläutert. Soweit Ausführungsbeispiele nicht als alternativ gekennzeichnet sind, können sie miteinander kombiniert werden.

Die Auswahl eines geeigneten Winkelpaares spielt für die Realisierung des Halbleiterbauelements der vorliegenden Erfindung eine große Rolle. Zahlreiche Winkelpaare haben sich als nicht geeignet herausgestellt, die D1- oder die D3-Emission hervorzuheben. Erfindungsgemäß ist das Winkelpaar derart eingestellt, dass in der Elektrolumineszenz des Halbleiterbauelements entweder im wesentlichen nur die D1- oder im wesentlichen nur die D3-Emission im Spektralbereich zwischen 0,7 und 1,1 eV zu beobachten ist. "Im wesentlichen" bedeutet: Geringfügige Beiträge anderer Lumineszenzen oder der strahlenden Band-Band-Rekombination können oft nicht verhindert werden, schmälern die Nutzbarkeit eines betreffenden Winkelpaars jedoch nicht.

Bei einer ersten Alternative beträgt der Drehwinkel zwischen 1,1 ° und 1,5 ° und der Kippwinkel zwischen 0,6 ° und 0,7 °. Auf diese Weise entsteht an der ersten Grenzfläche ein Versetzungsnetzwerk, das eine spektral begrenzte und intensive Lumineszenz hervorruft, die ganz überwiegend von der D1-Emission hervorgerufen wird.

Mit dem Licht emittierenden Halbleiterbauelement dieser Alternative gelingt es, die D1-Emission gegenüber den Emissionen D2 bis D4 sowie gegenüber der Band-Band-Emissionslinie bei 1,1 eV deutlich hervorzuheben. Auf diese Weise wird die spektrale Breite der Elektrolumineszenz des Halbleiterbauelements deutlich reduziert. Darüber hinaus erhöht sich aufgrund der Unterdrückung konkurrierender strahlender Energierelaxationsprozesse die Quanteneffizienz der Lichtemission im Bereich der D1-Lumineszenz.

Nachfolgend werden bevorzugte Ausführungsbeispiele des erfindungsgemäßen Licht emittierenden Halbleiterbauelements erläutert.

Bevorzugt beträgt der Drehwinkel 1,3 °.

Weiter bevorzugt beträgt der Kippwinkel 0,64 °.

In einem besonders bevorzugten Ausführungsbeispiel beträgt der Drehwinkel 1,3 ° und der Kippwinkel 0,64 °. Dabei sind die erste und zweite Siliziumschicht bevorzugt von zwei Siliziumscheiben mit (100)-Oberflächen gebildet. Nach heutiger Fertigungstechnik können der Drehwinkel und der Kippwinkel mit einer Genauigkeit von mindestens 0,1 ° hergestellt und bestimmt werden. Grundsätzlich ist es auch denkbar, anders als (100)-orientierte Siliziumscheiben zu verwenden, etwa (111) oder (010)-orientierte Siliziumscheiben. Jedoch liegen derzeit noch keine Erfahrungen damit vor.

In einer zweiten Alternative des erfindungsgemäßen Halbleiterbauelements beträgt der Drehwinkel zwischen 8,9 ° und 9,1 ° und der Kippwinkel zwischen 0,1 ° und 0,3 °. Mit dieser zweiten Alternative gelingt ebenfalls die Herstellung eines versetzungsnetzwerks an der ersten Grenzfläche, das eine intensive Lumineszenz hervorruft, die überwiegend von der D1-Emission hervorgerufen wird. Bevorzugt beträgt der Drehwinkel 9,0 °. Weiter bevorzugt beträgt der Kippwinkel 0,2 °. Besonders bevorzugt beträgt der Drehwinkel 9,0 ° und der Kippwinkel 0,2 °.

In einer dritten Alternative des erfindungsgemäßen Halbleiterbauelements beträgt der Drehwinkel zwischen 8,1 ° und 8,3 ° und der Kippwinkel zwischen 0,1 ° und 0,3 °. Mit dieser Alternative gelingt es, ein Versetzungsnetzwerk an der ersten Grenzfläche herzustellen, mit dem eine spektral begrenzte und intensive Lumineszenz hervorgerufen werden kann, die ganz überwiegend von der D3-Emission herrührt.

Es ist zu erwarten, dass weitere Wertepaare von Drehwinkeln und Kippwinkeln existieren, die dazu führen, dass das Elektrolumineszenzspektrum des Licht emittierenden Halbleiterbauelements ein absolutes Maximum bei der D1-Emission oder bei der D3-Emission hat.

Für die Intensität der D1-Lichtemission hat es sich als vorteilhaft herausgestellt, wenn eine geringfügige Dekoration des Versetzungsnetzwerks mit Sauerstoff vorliegt.

Die Oberflächen sind bevorzugt mit Hilfe eines Waferbonding-Verfahrens verbunden. Es existieren zwar zahlreiche etablierte Verfahren zur Herstellung von Versetzungen. Beispielsweise können Versetzungsnetzwerke mit Hilfe plastischer Deformation hergestellt werden, vgl. die eingangs zitierten Arbeiten von Kveder. Eine Alternative bietet die Erzeugung von Fehlanpassungsversetzungen (misfit dislocations) bei Abscheidung von Schichten mit unterschiedlichen Gitterkonstanten, wie zum Beispiel von Silizium-Germanium-Schichten auf einem Siliziumsubstrat. Versetzungsnetzwerke können auch durch Implantation von Ionen und anschließende Ausheilungsschritte erzeugt werden. Dabei können perfekte oder nicht perfekte Versetzungsschleifen (dislocation loops) entstehen oder stäbchenförmige Versetzungen (rod-like defects). Alle diese Verfahren haben jedoch den Nachteil, dass sie nicht mit der erforderlichen Präzision kontrollierbar und reproduzierbar sind. Das Waferbonding bietet gegenüber diesen Verfahren den Vorteil, die Dreh- und Kippwinkel präzise einzustellen und auf diese Weise besonders regelmäßige und gut reproduzierbare Versetzungsnetzwerke herzustellen.

Wie die Erfinder in umfangreichen Untersuchungen in Übereinstimmung mit der bekannten Fachliteratur feststellen konnten, haben schon relativ geringfügige Änderungen der Dreh- und Kippwinkel starke Auswirkungen auf die dadurch entstehenden Versetzungsstrukturen und auf die von ihnen hervorgerufenen Lichtemissionen im Bereich der Lumineszenzen D1 bis D4.

Bevorzugt ist die zweite Achse, die die Verkippung der ersten und zweiten Siliziumschicht zu einander definiert, parallel oder annähernd parallel zu einer < 110>-Richtung der Wafer.

Die erste Grenzfläche zwischen der ersten und zweiten Siliziumschicht liegt bevorzugt in einer Tiefe zwischen 100 und 300 nm unterhalb der Oberfläche des Substrats des Licht emittierenden Halbleiterbauelements. Besonders bevorzugt ist ein Abstand zur Substratoberfläche von 200 nm. Dieses Ausführungsbeispielwird vorteilhaft durch eine flache Implantation gleichzeitig mit der Ausbildung von Source- und Drain-Gebieten von Feldeffekttransistoren auf demselben Chip hergestellt.

Bei einem alternativen Ausführungsbeispiel ist die erste Grenzfläche in einem Abstand von mehr als 200 nm von der Substratoberfläche angeordnet. Bei diesem Ausführungsbeispiel wird die Dotierung von p- und n-Gebieten vorzugsweise im Zusammenhang mit einer Wannendotierung durchgeführt.

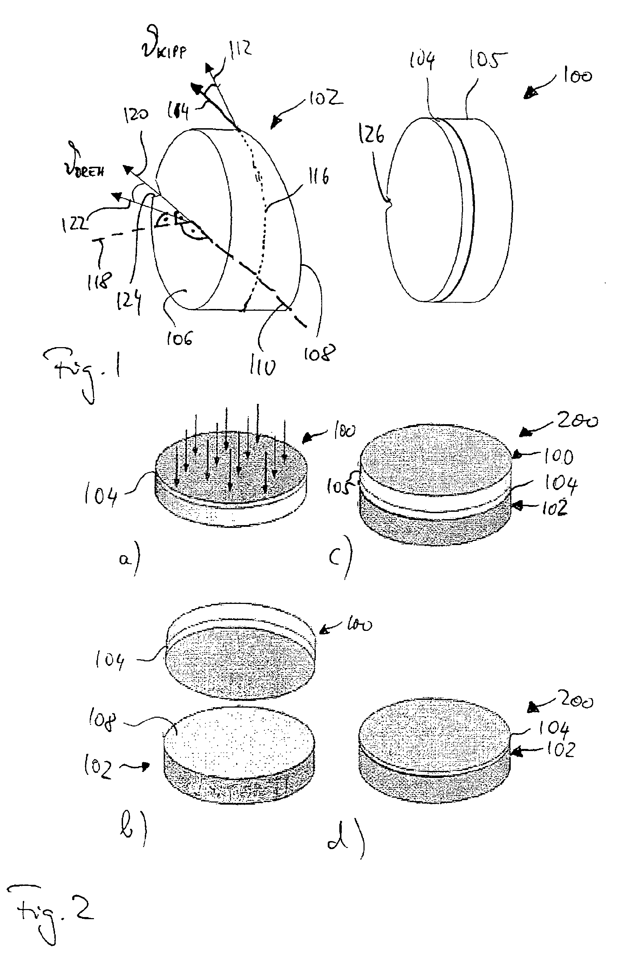

Selbstverständlich können jedoch auch separate Dotierungsschritte zur Herstellung der p- und n-dotierten Gebiete des Halbleiterbauelements vorgesehen sein. Weitere Einzelheiten der Dotierung werden im Zusammenhang der Beschreibung eines bevorzugten Ausführungsbeispiels anhand von Figur 2 erläutert.

Bei einem Beispiel, das hilfreich zum Verständnis der Erfindung ist, wird die Effizienz der D1-Emission oder der D3-Emission weiter erhöht, indem das Substrat zwei oder mehr Grenzflächen enthält, an denen ein entsprechendes Versetzungsnetzwerk gebildet ist. Aufgrund der Komplexität der Herstellung ist ein Halbleiterbauelement mit zwei Grenzfläche bevorzugt, bei dem die zweite Siliziumschicht an ihrer von der ersten Siliziumschicht abgewandten Seite mit einer dritten Siliziumschicht eine zweite Grenzfläche bildet, an der die zweite und dritte Siliziumschicht relativ zueinander um einen zweien Drehwinkel verdreht und um einen zweien Kippwinkel verkippt sind, derart, dass im Bereich der zweiten Grenzfläche ein Versetzungsnetzwerk vorliegt, wobei der zweite Drehwinkel und der zweite Kippwinkel so gewählt sind, dass ein Elektrolumineszenzspektrum des Halbleiterbauelements aus dem Gebiet des zweiten Versetzungsnetzwerks ein absolutes Maximum der emittierten Lichtintensität bei entweder 1,3 Mikrometern Lichtwellenlänge oder 1,55 Mikrometern Lichtwellenlänge aufweist.

Dabei ist die dritte Siliziumschicht auch von einem (100)-Silizium-wafer mit einer <110>-Richtung der zweiten Achse gebildet.

Bei verschiedenen alternativen Beispielen beträgt der zweite Drehwinkel zwischen 1,1 ° und 1,5 ° und der zweite Kippwinkel von 0,6 ° und 0,7 ° beträgt, oder der zweite Drehwinkel zwischen 8,9° und 9,1° und der zweite Kippwinkel zwischen 0,1 ° und 0,3 ° oder der zweite Drehwinkel zwischen 8,1 ° und 8,3 ° und der zweite Kippwinkel zwischen 0,1 ° und 0,3 °. Das Vorsehen von zwei oder mehr Grenzflächen mit Versetzungsnetzwerken gleicher Dreh- und Kippwinkel kann die Intensität der Lichtemission aus dem erfindungsgemäßen Halbleiterbauelement also deutlich erhöhen. Denkbar ist auch, die erste Grenzfläche für eine D1-Emission zu optimieren und die zweite Emission für eine D3-Emission zu optimieren. Auf diese Weise entsteht eine Lichtemission, die zwei getrennte, relativ schmalbandige Elektrolumineszenzmaxima aufweist. Durch geeignete elektrische oder optische Maßnahmen kann ermöglicht werden, nur eine der beiden Emissionen zu nutzen. Das Licht emittierende Halbleiterbauelement mit zwei Emissionspeaks in den spektral interessanten Bereichen von 1,3 Mikrometern und 1,55 Mikrometern wäre flexibel einsetzbar.

Das Licht emittierende Halbleiterbauelement hat einen n-dotierten Abschnitt und einen daran angrenzenden p-dotierten Abschnitt. Diese sind relativ zur ersten bzw. ersten und zweiten Grenzfläche in einer ersten Alternative so angeordnet, dass das Versetzungsnetzwerk, bei Vorhandensein mehrerer Grenzflächen die Versetzungsnetzwerke außerhalb einer sich bei Flusspolung des Halbleiterbauelements ausbildenden Sperrschicht liegt bzw. liegen. Auf diese Weise kann im Licht emittierenden Bereich an den Versetzungsnetzwerken nahe der Grenzflächen eine hohe Konzentration von Überschussladungsträgem erzielt werden. In einer zweiten Alternative sind ein n-dotierter Abschnitt und ein daran angrenzender p-dotierter Abschnitt vorgesehen, die relativ zur ersten bzw. ersten und zweiten Grenzfläche so angeordnet sind, dass das bzw. die Versetzungsnetzwerke innerhalb einer sich bei Flusspolung des Halbleiterbauelements ausbildenden Sperrschicht liegen.

Bei dem Licht emittierenden Halbleiterbauelement weist die Substratoberfläche mindestens zwei Teilflächen auf, von denen eine erste Teilfläche auf einer ersten Seite relativ zur ersten Grenzfläche und eine zweite Teilfläche auf einer zweiten Seite relativ zur ersten Grenzfläche liegt. Auf der ersten und zweiten Teilfläche ist jeweils mindestens ein Kontaktelement angeordnet. So gelingt durch Anlegen einer Vorspannung an die Kontaktelemente auf den beiden Teilflächen der Substratoberfläche eine Erhöhung der Intensität der Lichtemission aus dem Versetzungsbereich. Bevorzugt handelt es sich bei den Kontaktelementen um Ohmsche Kontaktelernente. Die Höhe der für eine Verbesserung der Emissionsintensität zu wählenden Vorspannung hängt von der Dotierung ab, ihr Vorzeichen kann beliebig gewählt werden.

Bevorzugte Ausführungsbeispiele des Licht emittierenden Halbleiterbauelements der vorliegenden Erfindung sind als Leuchtdiode oder als Laserdiode ausgebildet. Dies schließt insbesondere eine geeignete Kontaktierung der p- und n-Bereiche ein, die nach geläufigen Methoden aufgebracht werden kann. Die Herstellung einer Laserdiode erfordert bekanntermaßen die zusätzliche Schaffung eines Resonators, was beispielsweise durch eine Verspiegelung der Substratkanten oder alternativ der Substratoberflächen gelingt.

Weitere Einzelheiten und Ausführungsbeispiele der vorliegenden Erfindung werden nachfolgend mit Bezug auf die Figuren erläutert. Es zeigen:
- Figur 1: eine perspektivische Darstellung zweier Siliziumwafer zur Erläuterung der geometrischen Verhältnisse beim Waferbonding-Verfahren.
- Figur 2: in vier Teilfiguren a) bis d) wesentliche Verfahrensschritte bei der Herstellung des Substrats für ein Ausführungsbeispiel eines erfindungsgemäßen Lichtemitters.
- Figur 3: eine transmissionselektronenmikroskopische Aufnahme eines Versetzungsnetzwerks in einem erfindungsgemäßen Lichtemitter.
- Figur 4: Photolumiszenzspektren eines erfindungsgemäßen Lichtemitters bei unterschiedlichen Temperaturen.
- Fig. 5: Lumineszenspektren zweier weiterer Versetzungsnetzwerke bei alternativen Winkelpaaren.
- Fig. 6: eine schematische Querschnittsansicht eines weiteren Ausführungsbeispiels eines erfindungsgemäßen Licht emittierenden Halbleiterbauelements.
- Fig. 7: eine schematische Querschnittsansicht eines weiteren Ausführungsbeispiels eines erfindungsgemäßen Licht emittierenden Halbleiterbauelements.
- Fig.8: ein Diagramm mit einer schematischen Darstellung der Abhängigkeit der Lichtintensität von der Position beim Abtasten einer Querschnittsfläche eines Ausführungsbeispiels nach Fig. 6 oder Fig. 7 mit Hilfe eines Kathodolumineszenz-Messaufbaus.

Figur 1 zeigt in einer schematischen dreidimensionalen Ansicht zwei Wafer 100 und 102, die für die Herstellung des Substrats eines erfindungsgemäßen Lichtemitters verwendet werden.

Beim Wafer 100 handelt es sich um einen (100)-Siliziumwafer, in den durch einen Wasserstoffimplantationsschritt mit einer Dosis zwischen 1x10¹⁶-1x10¹⁷ cm⁻² Wasserstoffionen oder Heliumionen eingebracht sind. Die implantierte Schicht 104 erstreckt sich über eine Tiefe von etwa 200 nm von der Substratoberfläche aus.

Beim Wafer 102 handelt es sich ebenfalls um einen (100)-Siliziumwafer. Anders als beim Wafer 100 sind seine beiden Oberflächen 106 und 108 jedoch nicht parallel zueinander, sondern sind um einen kleinen Winkel ⊝_{KIPP} zueinander verkippt. Im Englischen wird diese Verkippung als "tilt" bezeichnet. Die Achse, um die die Fläche 108 zur Oberfläche 106 verkippt ist, liegt parallel zur <110>-Richtung und ist mit einer gestrichelten Linie 110 angedeutet. Der Winkel ⊝_{KIPP} zwischen einem Pfeil 112, der sich parallel zur Oberfläche 106 erstreckt und einem Pfeil 114, der sich parallel zur Oberfläche 108 erstreckt, ist zur Verdeutlichung eingezeichnet. Eine gepunktete Linie 116 deutet zum Vergleich den Verlauf der Unterkante des Wafers 102 in dem gedachten Falle an, in dem beide Oberflächen 106 und 108 parallel zueinander wären. Die Darstellung der Figur 1 ist stark übertrieben, um die geometrischen Verhältnisse deutlich darstellen zu können.

Weiterhin ist mit einer gestrichelten Linie 118 eine senkrecht zur Substratoberfläche 106 stehende Drehachse eingezeichnet. Beim Waferbonden sind der Wafer 100 und der Wafer 102 um einen definierten Winkel ⊝_{DREH} um die Drehachse 118 gegeneinander verdreht. Diese Verdrehung wird im Englischen als "twist" bezeichnet. Zwei Pfeile 120 und 122 dienen zur Andeutung der unterschiedlichen Ausrichtungen der Wafer 100 und 102 beim Waferbonden, wobei der Pfeil 120 in <110>-Richtung zeigt, die an den Wafern 100 und 102 zusätzlich durch Einkerbungen 124 und 126 angezeigt ist.

Bei dem derzeit bevorzugten Ausführungsbeispiel der Erfindung beträgt der Drehwinkel ⊝_{DREH} 1,3 ° und der Kippwinkel ⊝_{KIPP} 0,64°. Die Winkelangaben beziehen sich auf eine Skala zwischen 0 und 360 °. Es ist jedoch anzunehmen, dass weitere Kombinationen von Dreh- und Kippwinkel zu einer ähnlich schmalen und intensiven Lichtemission im Bereich der D1-Lumineszenz führen.

Figur 2 zeigt wesentliche Verfahrensschritte bei der Herstellung des Substrats eines erfindungsgemäßen Lichtemitters.

Bei der nachfolgenden Beschreibung wird auf die beiden Wafer 100 und 102 der Figur 1 Bezug genommen. Bei dem in Figur 2a) dargestellten ersten Verfahrensschritt wird Wasserstoff mit einer Dosis von 1 x 10¹⁶ - 1 x 10¹⁷ cm⁻² in den Wafer 100 implantiert, um die oberflächennahe Schicht 104 entstehen zu lassen. Dies ist in Figur 2a) durch Pfeile symbolisiert, die auf die Waferoberfläche gerichtet sind. Die oberflächenahe Schicht 104 wird in einem späteren Verfahrensschritt, dessen Ergebnis in Figur 2d) dargestellt ist, vom Rest des Substrats 100 getrennt (so genanntes "Smart-Cut"-Verfahren).

Bei dem in Figur 2b) dargestellten Verfahrensschritt wird der präparierte Wafer 100 mit der Oberflächenschicht 104 zu unterst auf den Wafer 102 aufgebracht, dessen Oberfläche 108 mit der Schicht 104 in Berührung tritt. Aufgrund in atomaren Dimensionen reiner und glatter Oberflächen haften die Substrate 100 und 102 aneinander, wobei intermolekulare Kräfte wie Van-der-Vahls-Kräfte oder Wasserstoffbindungen die Haftung bewirken. Durch eine anschließende Temperaturbehandlung des so entstandenen Substrats 200 wird die Haftung verstärkt. Zugleich wird mit Hilfe eines Smart-Cut-Prozesses die Schicht 105 vom Substrat 200 abgesprengt. Figur 2d) zeigt als Ergebnis das so präparierte Substrat 200, welches aus dem Wafer 102 und der Schicht 104 des Wafers 100 gebildet ist.

Für die Herstellung einer Leuchtdiode oder einer Laserdiode ist eine Ausbildung von p- und n-dotierten Regionen erforderlich. Diese Verfahrenschritte sind in Figur 2 nicht eigens dargestellt. Bei dem hier angegebenen Ausführungsbeispiel mit einer Tiefe der Grenzfläche von etwa 200 nm wird vorzugsweise in die Schicht 104 eine flache p- oder n-Dotierung eingebracht, bevor das Waferbonden durchgeführt wird. Die zusätzliche Dotierung mit Wasserstoff und/oder Helium für die Durchführung des Smart-Cut-Verfahrens stellt hierbei kein Hindernis für die Ausbildung eines gewünschten Dotierungsprofils dar.

Nach Durchführung des Smart-Cut-Verfahrens in dem in der Figur 2d) gezeigten Stadium wird ein weiterer Dotierungsschritt vom entgegengesetzten Ladungsträgertyp durchgeführt, um einen pn-Übergang entstehen zu lassen. Dabei werden Dosis, Energie und die Parameter der thermischen Nachbehandlung so eingestellt, dass die bei Flusspolung entstehende Sperrschicht oberhalb der Grenzfläche zum Substrat 102 liegt. Das Substrat 102 ist dabei vom selben Leitfähigkeitstyp wie der grenzflächennähere Dotierungsabschnitt der Schicht 104.

Das vorstehend beschriebene Dotierungsverfahren sieht eine Ausbildung des pn-Übergangs oberhalb der Grenzfläche vor, also in der Schicht 104. Der pn-Übergang kann jedoch auch im Substrat 102 ausgebildet werden. Hierbei wird das Substrat 102 entweder mit der erforderlichen p-Leitfähigkeit hergestellt und/oder nachträglich einem Dotierungsschritt des gewünschten Leitfähigkeitstyps unterzogen. Anschließend wird vor dem Schritt des Waferbondens eine weitere Dotierung mit dem entgegengesetzten Leitfähigkeitstyp durchgeführt. Hierbei werden die Energie, die Dosis und die Parameter der anschließenden thermischen Nachbehandlung des Substrats 102 so eingestellt, dass die sich bei Flusspolung ausbildende Sperrschicht in der gewünschten Tiefe unterhalb der Grenzfläche im Substrat 102 liegt.

Alternativ kann die letztgenannte Dotierung auch nach dem Waferbanden durchgeführt werden, wobei die Implantationsparameter entsprechend angepasst werden müssen. Die Dotierung der Schicht 104 erfolgt bei dieser letzten Variante vorzugsweise nach dem Waferbanden. Es ist jedoch auch möglich, diese Schicht vor dem Waferbanden zu dotieren.

In einem alternativen Ausführungsbeispiel liegt die Grenzfläche zwischen der Schicht 104 und der Schicht 102 in einem Abstand von der Substratoberfläche, der größer ist als 200 nm. Auch bei dieser Variante kann das beschriebene Smart-Cut-Verfahren angewendet werden. Es sind jedoch auch alternative Verfahren bekannt, die eine Trennung des Substrats 100 von der Schicht 104 ermöglichen. Damit kann die Schicht 104 mit beliebiger Dicke ausgebildet werden, wodurch die Grenzfläche zum Substrat 102 eine frei wählbare Tiefe bekommt. Es ist beispielsweise denkbar, dass je nach Dotierungsprofil ein größerer Abstand der Sperrschicht von der Grenzfläche mit dem Versetzungsnetzwerk einen positiven Einfluss auf die Überschussladungsträgerkonzentration und damit auf die Intensität oder Quanteneffizienz der Lichtemission hat.

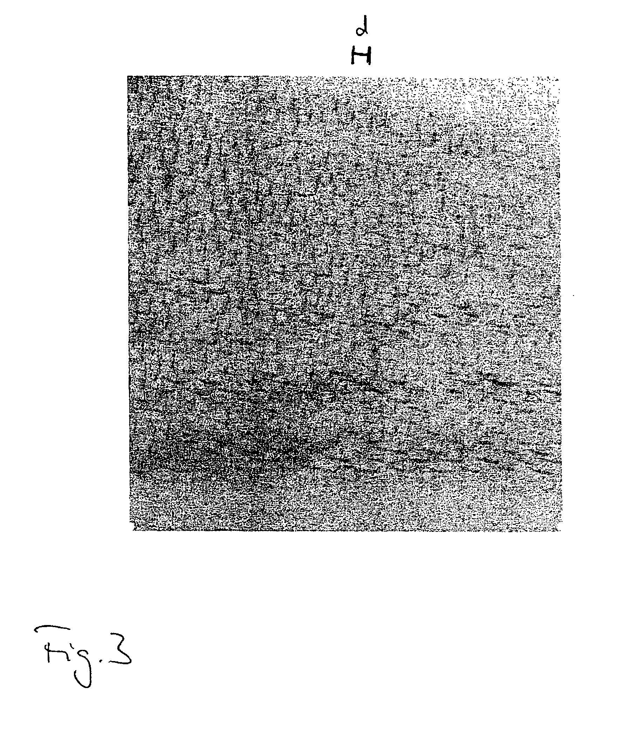

Figur 3 zeigt eine transmissionselektronenmikroskopische Aufnahme eines Versetzungsnetzwerks an der Grenzfläche zwischen der Schicht 104 und dem Wafer 100 des Substrats 200. Erkennbar ist ein regelmäßiges Muster von gegenüber dem Hintergrund dunkel abgesetzten Versetzungslinien, die einen Abstand d von ca. 20 nm voneinander haben. Das in Figur 3 dargestellte Versetzungsnetzwerk entsteht unter Verwendung eines Drehwinkels ⊝_{DREH} von 1,3 ° und eines Kippwinkels ⊝_{KIPP} von 0,64 °.

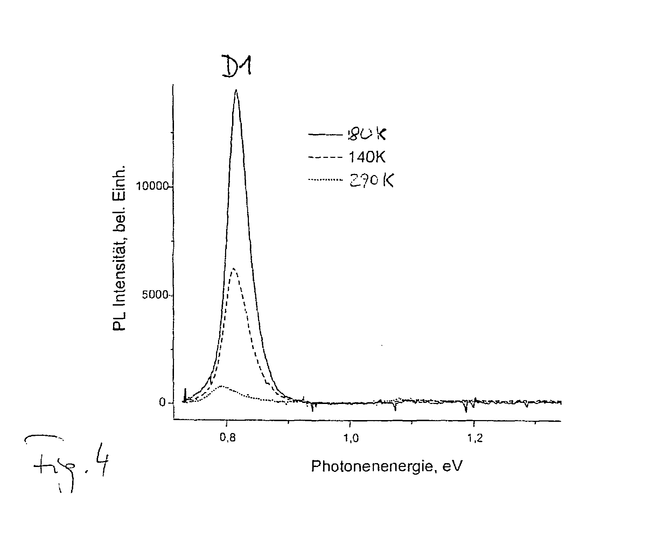

Figur 4 zeigt Photolumineszenzspektren des Substrats 200 bei Anregung mit Licht einer Energie oberhalb der Bandkante von Silizium. Dargestellt sind drei Photolumineszenzspektren im Spektralbereich zwischen etwa 0,75 eV und 1,3 eV. Ein mit durchgezogener Linie dargestelltes Spektrum wurde bei einer Substrattemperatur von 80 K aufgenommen. Ein mit einer gestrichelten Linie gekennzeichnetes Spektrum wurde bei einer Substrattemperatur von 140 K aufgenommen. Ein mit einer gepunkteten Linie dargestelltes Spektrum wurde bei einer Temperatur von 290 K aufgenommen. Dargestellt ist jeweils die Photolumineszenzintensität in beliebigen linearen Einheiten als Funktion der Energie der emittierten Photonen. Deutlich erkennbar ist, dass das Lumineszenzspektrum bei allen drei untersuchten Temperaturen nur einen einzigen deutlich erkennbaren Lumineszenzpeak aufweist, der anhand seiner energetischen Lage zweifelsfrei als D1-Lumineszenz identifiziert werden kann. Das Maximum der D1-Lumineszenz liegt bei Raumtemperatur bei einer Energie von knapp unter 0,8 eV, also genau im für optoelektronische Anwendungen besonders interessanten Spektralbereich. Das Lumineszenzspektrum zeigt bei Raumtemperatur eine äußerst geringe Asymmetrie der Linienform, die auf nur minimale Beiträge der D2-Lumineszenz zur Lichtemission schließen lässt. Bei tieferen Temperaturen ist die D2-Lumineszenz nicht wahrnehmbar.

Auffallend ist auch, dass die Band-Band-Rekombination zur Lumineszenz des Substrats nicht merklich beiträgt. Durch herkömmliche Dotierungs- und Kontaktierungsverfahren kann aus dem Substrat 200 eine effiziente Leuchtdiode hergestellt werden, die eine vergleichsweise schmalbandige und intensive Lichtemission bei 1,5 µm zeigt. Eine solche Leuchtdiode lässt sich unmittelbar in die siliziumbasierte Halbleitertechnologie einbinden. Dabei wird der pn-Übergang vorzugsweise so angeordnet, dass das Versetzungsnetzwerk, bei Vorhandensein mehrerer Grenzflächen die Versetzungsnetzwerke, außerhalb einer sich bei Flusspolung des Halbleiterbauelements ausbildenden Sperrschicht liegt bzw. liegen.

Erkennbar ist in der Darstellung der Figur 4 ebenfalls, dass die Intensität der D1-Lumineszenz mit der Temperatur abnimmt. Dieses Verhalten ist für zahlreiche Defektlumineszenzen in Halbleitern typisch und für den Betrieb einer Leucht- oder Laserdiode nicht hinderlich.

Das Maximum der D1-Lumineszenz liegt um etwa 0,36 eV unterhalb der Energie der Bandlücke des Silizium. Dieser Abstand bleibt auch mit zunehmender Temperatur konstant, bei der bekanntlich die Energie der Bandlücke sinkt.

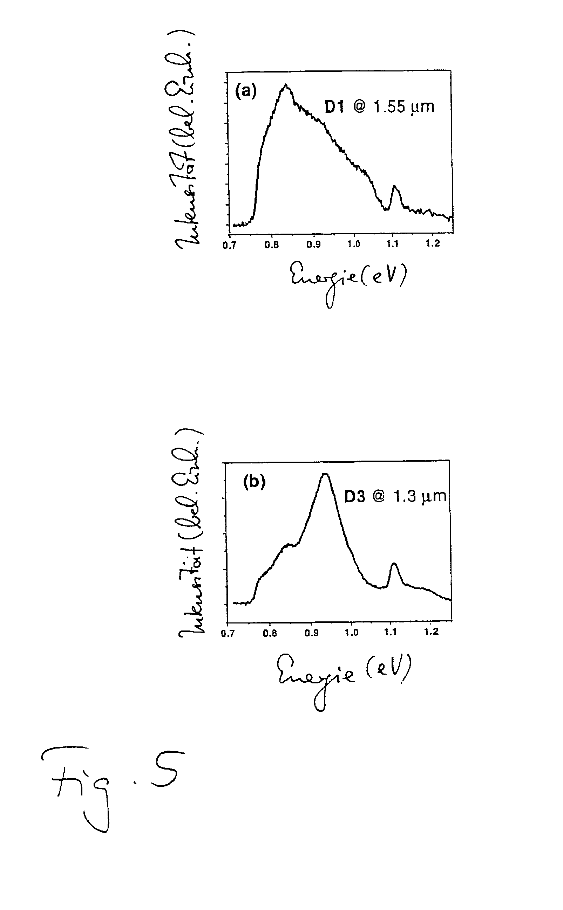

Figur 5 zeigt Lumineszenspektren zweier weiterer Versetzungsnetzwerke bei alternativen Winkelpaaren. Figur 5a) zeigt ein Lumineszenzspektrum eines Versetzungsnetzwerks, das durch Einstellung eines Drehwinkels von 9 ° und eines Kippwinkels von 0,2 ° entsteht. Das Spektrum wurde bei einer Temperatur von 80 K aufgenommen. Auch bei diesem Winkel dominiert die D1-Lumineszenz, wenn auch nicht so deutlich wie im Falle des Beispiels der Figur 4.

Figur 5b zeigt dagegen ein Lumineszenzspektrum eines Versetzungsnetzwerks, das durch Einstellung eines Drehwinkels von 8,2 ° und eines Kippwinkels von 0,2 ° entsteht. Hier dominiert die D3-Emission das bei 80 K aufgenommene Lumineszenzspektrum. Beiträge anderer Lumineszenzen wie etwa der D1-Emission und der Band-Band-Emission sind vergleichsweise gering. Mit dieser Winkelkombination kann also ein Licht emittierendes Halbleiterbauelement hergestellt werden, das überwiegend bei 1,3 Mikrometern Lichtwellenlänge emittiert.

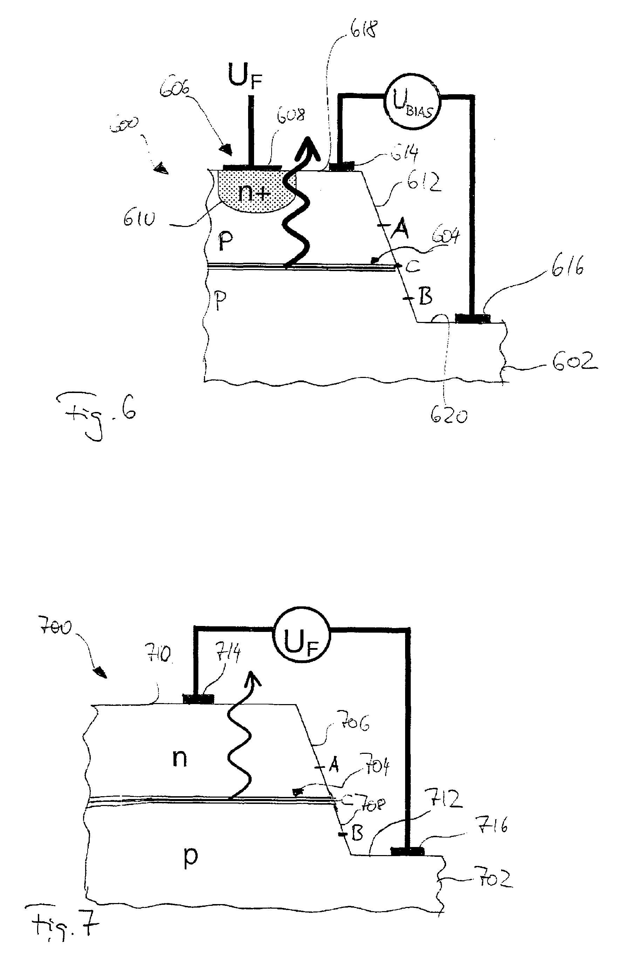

Fig. 6 zeigt eine schematische Querschnittsansicht eines weiteren Ausführungsbeispiels eines erfindungsgemäßen Licht emittierenden Halbleiterbauelements. Ein Lichtemitter 600 hat ein Substrat 602, das eine erste Grenzfläche 604 enthält, die nach dem anhand der Figuren 1 und 2 beschriebenen Verfahren hergestellt ist. Ein Steueranschluss 606 dient zum Anlegen einer Betriebsspannung U_{F} in Flusspolung einer Diodenstruktur, die von einem n-dotierten Bereich 610 und einer ersten Siliziumschicht 612 des Substrats 602 gebildet ist. Das Substrat 602 ist im vorliegenden Ausführungsbeispiel p-dotiert.

Weiterhin sind Kontaktelemente in Form von Vorspannungskontakten 614 und 616 vorgesehen, zwischen denen eine Vorspannung U_{BIAS} angelegt werden kann. Der erste Vorspannungskontakt 614 ist auf einer ersten Teilfläche 618 der Substratoberfläche angeordnet, die oberhalb der Grenzfläche 604 liegt. Der zweite Vorspannungskontakt 616 ist auf einer zweiten Teilfläche 620 der Substratoberfläche des Substrats 602 angeordnet, die unterhalb der Grenzfläche 604 liegt.

Beim Betrieb des Lichtemitters 600 werden durch Anlegung einer geeigneten Betriebsspannung U_{F} in Flusspolung Ladungsträger aus der n⁺-dotierten Region 610 in das Substratinnere hinein injiziert und erreichen die Grenzfläche 604, an der, wie bereits erläutert, Lichtemissionen auftreten und zu einer nach außen beobachtbaren Lichtabstrahlung führen. Die Intensität der Lichtabstrahlung kann durch Anlegen einer geeigneten Spannung U_{BIAS} erhöht werden. Eine geeignete Vorspannung U_{BIAS} ist beispielsweise 2 V. Der Betrag der Vorspannung sollte in Abhängigkeit von der Dotierung gewählt werden. Bei bisherigen Versuchen hat sich gezeigt, dass die Polung der Vorspannung für den Effekt der Erhöhung der Lichtintensität keine Rolle spielt. Derzeit wird vermutet, dass die Erhöhung der Lichtemission aus dem Versetzungsgebiet an der Grenzfläche 604 daher rührt, dass versetzungsbedingte Zustände mit Energieniveaus in der Bandlücke des Halbleitermaterials bei Anlegen der Vorspannung U_{BIAS} umgeladen werden, was die Rekombinationswahrscheinlichkeit erhöht.

Figur 7 zeigt ein alternatives Ausführungsbeispiel eines Lichtemitters 700 mit einem Substrat 702 und einer Grenzfläche 704 zwischen zwei Siliziumschichten 706 und 708, die ebenfalls durch ein Verfahren entsprechend dem in Fig. 1 und Fig. 2 beschriebenen Herstellungsverfahren erzeugt wird. Bei dem Lichtemitter 700 ist die erste Halbleiterschicht 706 n-dotiert und die zweite Halbleiterschicht 708 p-dotiert. Ähnlich wie der Lichtemitter 600 der Fig. 6 hat der Lichtemitter 700 eine Substratoberfläche, die zwei Teilflächen 710 und 712 aufweist. Auf der ersten Teilfläche 710 ist ein Kontakt 714 angeordnet, auf der zweiten Teilfläche 712 ist ein Kontaktelement 716 angeordnet. Wiederum ist das erste Kontaktelement 714 oberhalb der Grenzfläche 704 und das zweite Kontaktelement 716 unterhalb der Grenzfläche 704 angeordnet.

Auch mit dem in Fig. 7 gezeigten Aufbau gelingt es bei Anlegen einer Betriebsspannung U_{F} in Flusspolung, eine gegenüber herkömmlichen Anordnungen erhöhte Lichtintensität aus dem Bereich der Grenzfläche 704 anzuregen. Es versteht sich, dass die Dotierung der Siliziumschichten 706 und 708 des Substrats 702 auch umgekehrt sein kann.

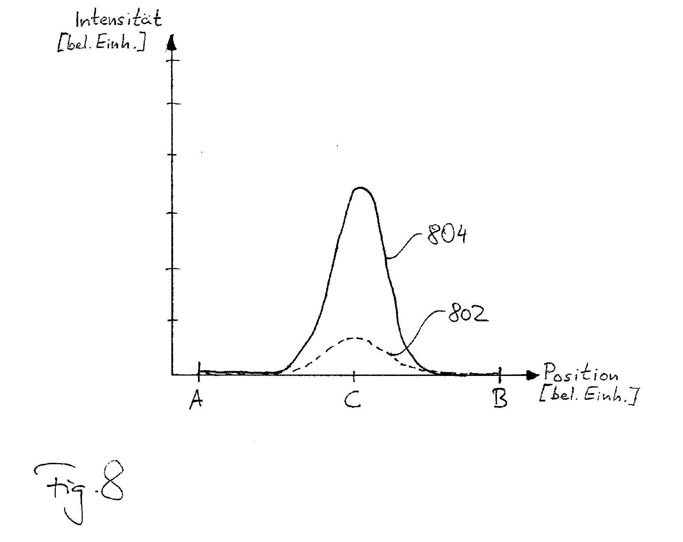

Fig. 8 zeigt ein Diagramm mit einer schematischen Darstellung der Abhängigkeit der Lichtintensität von der Position beim Abtasten einer Querschnittsfläche eines Ausführungsbeispiels nach Fig. 6 oder Fig. 7 mit Hilfe eines Katodolumineszenz-Messaufbaus. Das Diagramm der Fig. 8 zeigt die Abhängigkeit der Intensität der Katodolumineszenz (aufgetragen in beliebigen linearen Einheiten) in Abhängigkeit von der Position der die Lumineszenz anregenden Elektronenstrahlsonde, die an der x-Achse ebenfalls in beliebigen Einheiten dargestellt ist. Die Abtastrichtung erfolgte für die in Fig. 8 dargestellte Messung entlang einer Seitenfläche, die in den Beispielen der Fig. 6 und 7 senkrecht zur Papierebene verläuft. Beginn und Ende des Abtastens sind in Fig. 6 und 7 beispielhaft als Positionen A und B gekennzeichnet und ebenso in Fig. 8 an der x-Achse wiedergegeben. Eine erste Kurve 802 wurde bei einem Wert der Betriebsspannung von U_{F} = 0 V gemessen. Die mit durchgezogener Linie gezeichnete Kurve 804 wurde bei einem Wert der Betriebsspannung U_{F} von 2 V gemessen. Ein gleichartiger Intensitätsverlauf ergibt sich auch beim Beispiel der Fig. 6, wobei jedoch stets bei Flusspolung der Spannung U_{F} gemessen wird und die beiden Kurven 802 und 804 den Vorspannungswerten U_{BIAS} = 0 V (Kurve 802) und U_{BIAS} = 3 V (Kurve 804) entsprechen. Das hier schematisch wiedergegebene Messergebnis zeigt, dass die Intensität der Lichtemission aus dem Versetzungsbereich an der Position C des Versetzungsnetzwerkes bei Anlegen einer Vorspannung deutlich höher ist als bei fehlender Vorspannung.

## Patentansprüche

1. Licht emittierendes Halbleiterbauelement (600, 700) mit einem Substrat (602, 702), in dem ein n-dotierter Abschnitt (610, 706) und ein daran angrenzender p-dotierter Abschnitt (602, 702) vorhanden sind, **dadurch gekennzeichnet, dass**
das Substrat eine Grenzfläche (604, 704) zwischen einer ersten (602, 702) und einer zweiten Siliziumschicht (612, 706) aufweist, deren als ideal gedachte Gitterstrukturen relativ zueinander um eine senkrecht zu einer Substratoberfläche (106) stehende erste Achse (118) um einen Drehwinkel (θ_{Dreh}) verdreht und um eine zweite parallel zur Substratoberfläche liegende Achse (110) um einen Kippwinkel (θ_{Kipp}) verkippt sind, derart, dass im Bereich der Grenzfläche ein Versetzungsnetzwerk vorliegt,
die Substratoberfläche mindestens zwei Teilflächen (618, 620; 710, 712) aufweist, von denen eine erste Teilfläche (618, 710) auf einer ersten Seite (A) der Grenzfläche und eine zweite Teilfläche (620, 712) auf einer zweiten Seite (B) der Grenzfläche liegt;
auf der ersten und zweiten Teilfläche jeweils mindestens ein Kontaktelement (608, 616; 714, 716) angeordnet ist;
der Drehwinkel und der Kippwinkel so gewählt sind, dass ein bei Anlegen einer geeigneten Betriebsspannung (U_{F}) in Flusspolung an die Kontaktelemente aufnehmbares Elektrolumineszenzspektrum des Halbleiterbauelements ein absolutes Maximum der emittierten Lichtintensität (D1, D3) bei entweder 1,3 Mikrometern Lichtwellenlänge oder 1,55 Mikrometern Lichtwellenlänge aufweist, wobei
gemäß einer ersten Alternative der Drehwinkel zwischen 1,1 ° und 1,5 ° beträgt und der Kippwinkel zwischen 0,6 ° und 0,7 ° beträgt, oder
gemäß einer zweiten Alternative der Drehwinkel zwischen 8,9 ° und 9,1 ° beträgt und der Kippwinkel zwischen 0,1 ° und 0,3 ° beträgt, oder
gemäß einer dritten Alternative der Drehwinkel zwischen 8,1 ° und 8,3 ° beträgt und der Kippwinkel zwischen 0,1 ° und 0,3 ° beträgt,
und dass der n-dotierte Abschnitt (610, 706) und der p-dotierte Abschnitt (602, 702) relativ zur Grenzfläche so angeordnet sind, dass das Versetzungsnetzwerk entweder innerhalb oder außerhalb einer sich bei Flusspolung des Halbleiterbauelements ausbildenden Sperrschicht liegt.

2. Licht emittierendes Halbleiterbauelement nach der ersten Alternative des Anspruchs 1, bei dem der Drehwinkel 1,3 ° beträgt.

3. Licht emittierendes Halbleiterbauelement nach der ersten Alternative des Anspruchs 1 oder nach Anspruch 2, bei dem der Kippwinkel 0,64 ° beträgt.

4. Licht emittierendes Halbleiterbauelement nach der zweiten Alternative des Anspruchs 1, bei dem der Drehwinkel 9,0 ° beträgt.

5. Licht emittierendes Halbleiterbauelement nach der zweiten Alternative des Anspruchs 1 oder nach Anspruch 4, bei dem der Kippwinkel 0,2 ° beträgt.

6. Licht emittierendes Halbleiterbauelement nach der dritten Alternative des Anspruchs 1, bei dem der Drehwinkel 8,2 ° beträgt.

7. Licht emittierendes Halbleiterbauelement nach einem der vorstehenden Ansprüche, bei dem die erste und zweite Siliziumschicht von zwei Siliziumscheiben (100, 102) mit (100)-Oberflächen gebildet sind, die mit Hilfe eines Waferbonding-Verfahrens verbunden sind.

8. Licht emittierendes Halbleiterbauelement nach Anspruch 7, bei dem die zweite Achse (110) parallel zu einer <110>-Richtung der Siliziumscheiben (100, 102) liegt.

9. Licht emittierendes Halbleiterbauelement nach einem der vorstehenden Ansprüche, bei dem die erste Grenzfläche (604, 704) zwischen 100 und 300 nm unterhalb der Substratoberfläche angeordnet ist.

10. Licht emittierendes Halbleiterbauelement nach einem der Ansprüche Anspruch 1 bis 8, bei dem die erste Grenzfläche (604, 704) einen Abstand von mehr als 200 nm von der Substratoberfläche hat.

11. Licht emittierendes Halbleiterbauelement nach einem der vorstehenden Ansprüche, das als Leuchtdiode (600, 700) ausgebildet ist.

12. Licht emittierendes Halbleiterbauelement nach einem der vorstehenden Ansprüche, das als Laserdiode ausgebildet ist.

13. Licht emittierendes Halbleiterbauelement nach einem der vorstehenden Ansprüche, bei dem die Kontaktelemente (608, 616; 714, 716) Ohmsche Kontaktelemente sind.

## Claims

1. Light-emitting semiconductor component (600,700) having a substrate (602, 702) in which an n-doped section (610, 706) and an adjacent p-doped section (602, 702) are present, **characterised in that**
the substrate has an interface (604, 704) between a first (602, 702) and a second silicon layer (612, 706), the lattice structures of which, considered ideal, are rotated relative to one another through a rotation angle (θ_{Dreh}) about a first axis (118) standing perpendicular to a substrate surface (106) and have been tilted through a tilt angle (θ_{Kipp}) about a second axis (110) lying parallel to the substrate surface such that there is a dislocation network in the region of the interface,
the substrate surface comprises at least two partial surfaces (618, 620; 710, 712), of which a first partial surface (618, 710) is situated on a first side (A) of the interface and a second partial surface (620, 712) is situated on a second side (B) of the interface;
at least one contact element (608, 616; 714, 716) is arranged on each of the first and second partial surfaces;
the rotation angle and the tilt angle are selected so that an electroluminescence spectrum of the semiconductor component that can be recorded when a suitable operating voltage (U_{F}) in flux polarity is applied to the contact elements has an absolute maximum of the emitted light intensity (D1, D3) at a light wavelength of either 1.3 µm or 1.55 µm, while
according to a first alternative the rotation angle is between 1.1 ° and 1.5° and the tilt angle is between 0.6° and 0.7°, or
according to a second alternative the rotation angle is between 8.9° and 9.1 ° and the tilt angle is between 0.1° and 0.3°, or
according to a third alternative the rotation angle is between 8.1° and 8.3° and the tilt angle is between 0.1° and 0.3°,
and **in that** the n-doped section (610, 706) and the p-doped section (602, 702) are arranged relative to the interface such that the dislocation network is located either inside or outside a barrier layer formed at flux polarity of the semiconductor component.

2. Light-emitting semiconductor component according to the first alternative in claim 1, wherein the rotation angle is 1.3°.

3. Light-emitting semiconductor component according to the first alternative of claim 1 or according to claim 2, wherein the tilt angle is 0.64°.

4. Light-emitting semiconductor component according to the second alternative of claim 1, wherein the rotation angle is 9.0°.

5. Light-emitting semiconductor component according to the second alternative of claim 1 or according to claim 4, wherein the tilt angle is 0.2°.

6. Light-emitting semiconductor component according to the third alternative of claim 1, wherein the rotation angle is 8.2°.

7. Light-emitting semiconductor component according to one of the preceding claims, wherein the first and second silicon layers are formed by two silicon slices (100, 102) with (100)-surfaces that are joined together by a wafer-bonding process.

8. Light-emitting semiconductor component according to claim 7, wherein the second axis (110) lies parallel to a <110> direction of the silicon slices (100, 102).

9. Light-emitting semiconductor component according to one of the preceding claims, wherein the first interface (604, 704) is arranged between 100 and 300 nm below the substrate surface.

10. Light-emitting semiconductor component according to one of claims 1 to 8, wherein the first interface (604, 704) is at a spacing of more than 200 nm from the substrate surface.

11. Light-emitting semiconductor component according to one of the preceding claims which is embodied as a light-emitting diode (600, 700).

12. Light-emitting semiconductor component according to one of the preceding claims which is embodied as a laser diode.

13. Light-emitting semiconductor component according to one of the preceding claims, wherein the contact elements (608, 616; 714,716) are ohmic contact elements.

## Revendications

1. Composant semi-conducteur (600, 700) émettant de la lumière comprenant un substrat (602, 702), dans lequel une section dopée N (610, 706) et une section dopée P (602, 702) adjacente à cette dernière sont présentes, **caractérisé en ce que**
le substrat présente une interface (604, 704) entre une première couche de silicium (602, 702) et une deuxième couche de silicium (612, 706), dont les structures de réseau idéales sont pivotées les unes par rapport aux autres selon un angle de rotation (θ_{rot.}) autour d'un premier axe (118) perpendiculaire par rapport à une surface de substrat (106) et sont inclinées selon un angle d'inclinaison (θ_{incl.}) autour d'un deuxième axe (110) parallèle par rapport à la surface de substrat, de manière à créer un réseau de dislocation dans la zone de l'interface,
la surface de substrat présente au moins deux faces partielles (618, 620 ; 710, 712), parmi lesquelles une première face partielle (618, 710) se trouve sur un premier côté (A) de l'interface et une deuxième surface partielle (620, 712) se trouve sur un deuxième côté (B) de l'interface,
au moins un élément de contact (608, 616 ; 714, 716) est disposé respectivement sur la première face partielle et sur la deuxième face partielle,
l'angle de rotation et l'angle d'inclinaison sont choisis de telle manière qu'un spectre d'électroluminescence, pouvant être absorbé lors de l'application d'une tension de service (U_{F}) appropriée polarisée dans le sens de la conduction au niveau des éléments de contact, du composant semi-conducteur présente un maximum absolu de l'intensité lumineuse (D1, D3) émise pour une longueur d'onde lumineuse soit de 1,3 micromètre ou soit de 1,55 micromètre, dans lequel
selon une première variante, l'angle de rotation est compris entre 1,1° et 1,5°, et l'angle d'inclinaison est compris entre 0,6° et 0,7° ou
selon une deuxième variante, l'angle de rotation est compris entre 8,9° et 9,1° et l'angle d'inclinaison est compris entre 0,1° et 0,3° ou
selon une troisième variante, l'angle de rotation est compris entre 8,1° et 8,3° et l'angle d'inclinaison est compris entre 0,1° et 0,3°,
et **en ce que** la section dopée N (610, 706) et la section dopée P (602, 702) sont disposées par rapport à l'interface de telle manière que le réseau de dislocation se trouve soit à l'intérieur ou à l'extérieur d'une couche de blocage se formant lors de la polarisation dans le sens conducteur du composant semi-conducteur.

2. Composant semi-conducteur émettant de la lumière selon la première variante de la revendication 1, dans lequel l'angle de rotation est de 1,3°.

3. Composant semi-conducteur émettant de la lumière selon la première variante de la revendication 1 ou selon la revendication 2, dans lequel l'angle d'inclinaison est de 0,64°.

4. Composant semi-conducteur émettant de la lumière selon la deuxième variante de la revendication 1, dans lequel l'angle de rotation est de 9,0°.

5. Composant semi-conducteur émettant de la lumière selon la deuxième variante de la revendication 1 ou selon la revendication 4, dans lequel l'angle d'inclinaison est de 0,2°.

6. Composant semi-conducteur émettant de la lumière selon la troisième variante de la revendication 1, dans lequel l'angle de rotation est de 8,2°.

7. Composant semi-conducteur émettant de la lumière selon l'une quelconque des revendications précédentes, dans lequel la première couche de silicium et la deuxième couche de silicium sont formées par deux tranches de silicium (100, 102) dotées de surfaces (100), qui sont reliées à l'aide d'une technique de « wafer-bonding » (procédé de collage par adhésion moléculaire).

8. Composant semi-conducteur émettant de la lumière selon la revendication 7, dans lequel le deuxième axe (110) est parallèle à une direction <110> des tranches de silicium (100, 102).

9. Composant semi-conducteur émettant de la lumière selon l'une quelconque des revendications précédentes, dans lequel la première interface (604, 704) est disposée sous la surface de substrat à une distance comprise entre 100 et 300 nm.

10. Composant semi-conducteur émettant de la lumière selon l'une quelconque des revendications 1 à 8, dans lequel la première interface (604, 704) présente une distance de plus de 200 nm de la surface de substrat.

11. Composant semi-conducteur émettant de la lumière selon l'une quelconque des revendications précédentes, lequel se présente sous la forme d'une diode électroluminescente (600, 700).

12. Composant semi-conducteur émettant de la lumière selon l'une quelconque des revendications précédentes, lequel se présente sous la forme d'une diode laser.

13. Composant semi-conducteur émettant de la lumière selon l'une quelconque des revendications précédentes, dans lequel les éléments de contact (608, 616 ; 714, 716) sont des éléments de contact ohmiques.
